Europäisches Patentamt

European Patent Office

Office européen des brevets

(11) Publication number: **0 051 165**
**A1**

# (12) EUROPEAN PATENT APPLICATION

(21) Application number: **81108107.4**

(22) Date of filing: **09.10.81**

(51) Int. Cl.³: **H 01 L 23/14**

(30) Priority: **03.11.80 US 203340**

(43) Date of publication of application:
**12.05.82 Bulletin 82/19**

(84) Designated Contracting States:
**BE DE FR GB IT NL**

(71) Applicant: **BURROUGHS CORPORATION**
**Burroughs Place**
**Detroit, Michigan 48232(US)**

(72) Inventor: **Andrews, Daniel Marshall**
**1532 Shadow Hills**
**San Marcos, CA 92609(US)**

(72) Inventor: **Hoge, Carl Edward**
**1329 Diamond Head**
**Encinitas, CA 92024(US)**

(74) Representative: **Eisenführ, Günther, Dipl.-Ing et al,**
**Eisenführ & Speiser Martinistrasse 24**
**D-2800 Bremen 1(DE)**

(54) **Repairable IC package with thermoplastic chip attach.**

(57) Disclosed is an integrated circuit package that is comprised of a substrate (12), a first integrated circuit chip (11a), and a thermoplastic material (20a) which rigidly attaches the first chip to the substrate. This thermoplastic material is an organic polymer capable of repeatedly being softened when heated and hardened again when cooled, such as polyethylene. The thermoplastic material is disposed on the substrate in a manner that enables the first chip to be removed and to be replaced with a second chip by a softening-hardening sequence.

Fig. 1B

EP 0 051 165 A1

-1-

TITLE

REPAIRABLE IC PACKAGE WITH
THERMOPLASTIC CHIP ATTACH

BACKGROUND OF THE INVENTION

This invention relates to the art of packaging electronic circuits; and more particularly to, the art of packaging integrated circuit (IC) chips.

Basically, an IC chip is comprised of a semiconductor on which various interconnected circuit elements, such as transistors and diodes for example, are fabricated. Thousands of these circuit elements are often integrated on a single chip. A typical chip is 20 mils thick, and is 250 mils by 250 mils on a side.

Included as part of the interconnections on a chip are a plurality of metal pads. Leads are bonded to these pads after the chip is fabricated to provide a means for externally sending electrical signals to and externally receiving electrical signals from the circuitry on the chip.

However, since the pads are quite small (e.g., - 5 mils by 5 mils), the leads are quite fragile. Thus the leads must be kept short (e.g. - less than 0.5 inches). Then, in a single-chip IC package, each chip is attached to a rigid substrate; and the ends of the leads are bonded to etched conductors on that substrate. Interconnections among several chips are then made by contacting the etched conductors.

There are, however, several unattractive limitations in the above described single-chip package. And attempts to overcome those limitations have given rise to a multichip package. In the multichip package, several chips are attached to the substrate; leads are bonded from the pads on each of the attached chips to etched conductors on the substrate; and those etched conductors interconnect the attached chips in a predetermined fashion. Interconnections among several multichip packages are also made by contacting the etched conductors.

Such multichip packages are attractive because typically, the cost of an N-chip package is less than N times the cost of a single-chip package. Another attractive feature is that typically, the size of an N-chip package is less than N times the size of one single-chip package. Further, since inter-chip connections occur on the substrate in a multichip package, wire length and capacitances between chips are reduced; and also the total number of external connections are reduced.

However, a major problem with the prior art multichip packages relates to their repairability. For example, with many of the prior art multichip packages, it is difficult if not impossible to remove one chip from the package and replace it with another chip. This problem exists for example in those multichip packages where the chips are attached to the substrate by an adhesive material that is cured. Such material includes epoxies and thermal setting adhesives for example.

Once these materials are cured, they can no longer be melted by reheating them to the curing temperature. This is because during the curing operation, the molecules in the material cross-link, which in turn completely changes the material's chemical characteristics. Consequently, a cured material cannot be melted by heat and rehardened again when cooled. Instead, when heated, a cured material burns, or it decomposes and vaporizes; and a solid charred residue remains on the substrate.

This residue must be scraped from the substrate before another die can be attached to it. Otherwise, the thermal and electrical conductivity between the die and the substrate will be impaired; and also, the top surface of the newly added chip could be too far above the substrate to be within a prespecified height tolerance. Then, after the residue has been removed, the time consuming curing and postcuring operations are required to attach the new chip to the substrate.

One alternative to the above-described repair procedure, of course, would be to simply throw the entire N-chip package away; and to replace it with another N-chip package. But that would mean that N-1 good chips would be wasted. And in many cases, the individual chips in a package are very complex and thus are expensive to manufacture. For example, each chip might be a $100 microprocessor chip.

Further, in many cases, it is impossible to completely test each chip until after it has been attached to the substrate in the package. For example, the bonding pads on the chip may be too fragile to probe with test equipment. Also, the cost of testing the chip for dynamic failure modes may be prohibitive. Further, the chip may deteriorate with age; or it may fail only under certain peculiar temperature/humidity conditions if it is marginal.

Thus, in an effort to solve the repairability problem, a "chip carrier - mother board" IC package has been devised in the prior art. This package is described and illustrated, for example, in the publications entitled "Chip Carrier: Application and Future Direction", Electronic Packaging and Production Magazine, July, 1980 and "Growing Pin Count Is Forcing LSI Package Changes", Electronic Magazine, March 17, 1977.

As therein illustrated, the chips of the package are attached via an epoxy or a eutectic alloy to respective chip carriers; leads are bonded between the pads on the chips and conductors on the chip carriers; and the chip carriers are attached to the mother board by soldering the chip carrier conductors to other conductors on the mother board. Then to replace a chip, this solder is melted and the chip along with its chip carrier is discarded.

Clearly, one problem with this package is that it is expensive - since each chip carrier is an added item. Also, the space that is occupied by the chip carrier increases the overall size of the package. Further, the chip carrier increases the length and capacitance of the conductors which interconnect the chips in the package. Thus, while a "chip carrier - mother board" package is readily repairable, that package is deficient in those areas which originally made multichip packages more attractive than single-chip packages.

U.S. Patents 3,805,123 and 4,012,832 also describe other repairable IC packages. But the present invention is clearly distinguishable over the devices there disclosed.

In '123 for example, a curable adhesive is inseparably adhered to one surface of the semiconductor device; the curable adhesive is also inseparably adhered to a surface of substrate; and an intermediate layer of material which can be split into sheets is inseparably adhered between the curable adhesive on the semiconductor device and the substrate. Then, to detach the semiconductor device from the substrate, an impulse is applied to the device in a direction parallel to the substrate to split the intermediate layer. By comparison in the present invention, there are no layers of any curable adhesive, and no intermediate layer of a splittable material.

Similarly, in Patent '832, another laminated structure is disclosed. That structure is comprised of an epoxy attached to the semiconductor, an epoxy attached to the substrate, and a metal alloy lying between and attached to the two epoxy layers. To replace the semiconductor device in this structure, the alloy is melted; the epoxy is scraped from the substrate; respective layers of epoxy are reapplied to the substrate and to a new chip; a new alloy layer is placed beween the epoxy layers; and the alloy is melted then cooled as the epoxy layers are held together. But by comparison in the presently disclosed invention, there are no epoxy layers and no alloy layer at all.

Accordingly, it is a primary object of this invention to provide a novel repairable multichip IC package.

## BRIEF SUMMARY OF THE INVENTION

These and other objects are accomplished in accordance with the invention by an integrated circuit package which is comprised of a substrate, a first integrated circuit chip, and a thermoplastic material that rigidly attaches the first chip to the substrate. As used herein, the term thermoplastic material includes any organic polymer capable of repeatedly being softened when heated and hardened again when cooled. Exemplary thermoplastic materials for use in this invention include polyethylene, polysulfone, polyphenylene sulfide, acrylics, nylon, phenylene oxide, polycarbonate, polypropylene, polystyrene, and polyvinyl.

This thermoplastic material is disposed in the IC package in the manner that enables the first chip to be removed from the substrate and replaced with a second chip by a softening-hardening sequence. In one preferred embodiment, the substrate has a cavity; the thermoplastic material partially fills the cavity; and the first chip has a backside surface which is imbedded in the thermoplastic material. In another preferred embodiment, the substrate has a substantially flat major surface; a layer of the thermoplastic material covers a predetermined portion of the major surface; and the first chip has a backside surface imbedded in the thermoplastic material.

## BRIEF DESCRIPTION OF THE DRAWINGS

Various features and advantages of the invention will best be understood by reference to the following detailed description and accompanying drawings wherein:

Figure 1A is an enlarged photograph of one preferred embodiment of an IC package that is constructed in accordance with the invention.

Figure 1B is a cross-sectional drawing of the Figure 1A embodiment.

Figures 2A-2D are cross-sectional drawings which illustrate the process of attaching an integrated circuit chip to the IC package of Figure 1A.

Figures 3A-3B are cross-sectional drawings which illustrate the process of detaching an integrated circuit chip from the IC package of Figure 1A.

DETAILED DESCRIPTION OF THE INVENTION

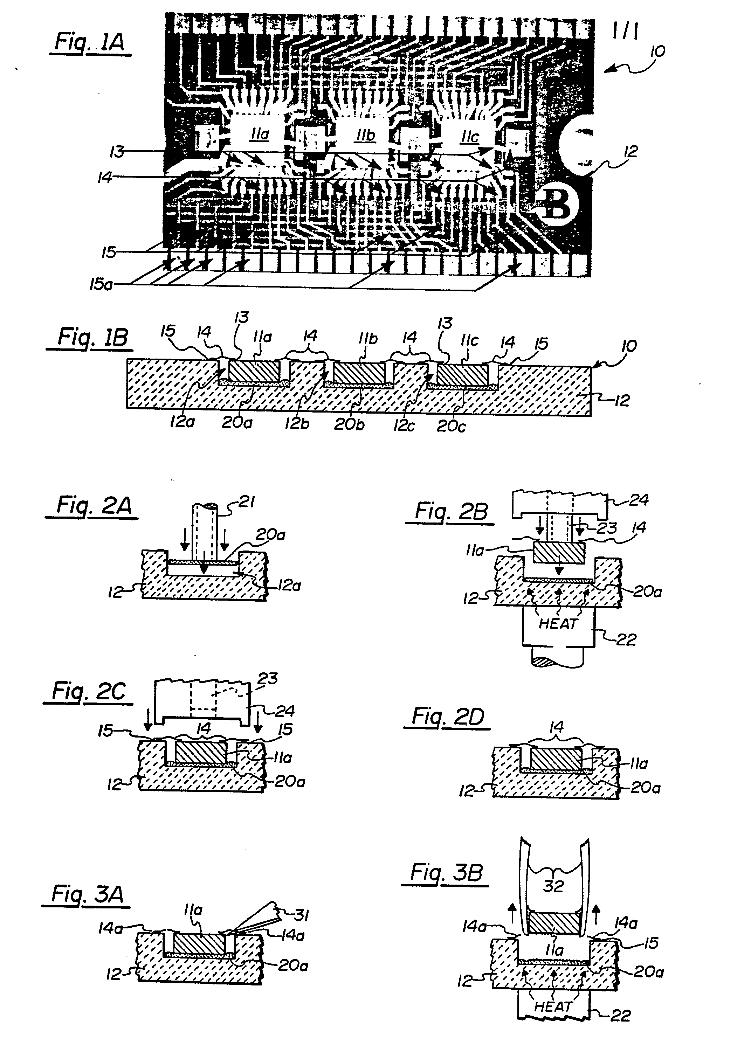

Turning now to Figures 1A and 1B, one preferred embodiment 10 of the invention will be described in detail. In this embodiment, three chips 11a, 11b, and 11c are repairably attached in cavities 12a, 12b, and 12c of a rigid ceramic substrate 12. · That is, in the event that one of those chips is found to be defective after it is attached, that defective chip can easily be removed and replaced with another non-defective chip.

But before preceding with the details of the repair procedure, all of the other components in IC package 10 will now be identified. They include a plurality of metal pads 13 which are located at the perimeter of chips 11a, 11b, and 11c. These metal pads are an integral part of the chips; and they provide contact points for sending electrical signals to and receiving electrical signals from the chips.

A plurality of leads 14 are respectively bonded at one end thereof to the metal pads. And the other end of the leads 14 are respectively bonded to a plurality of etched conductors 15 on substrate 12. These conductors make various electrical connections among the chips as illustrated; and they also provide rigid contact points 15a at which interconnections between several chips can be made.

Turning now to Figures 2A-2D, a preferred process for attaching the chips to the substrate will be described in detail. In this description, reference will only be made to chip 11a. But the attachment process is the same, and is simply repeated, for each of the other chips 11b and 11c.

As an initial step, a vacuum tool 21 places a thin piece (e.g. - 5 mils) of thermoplastic material 20a at the bottom of cavity 12a. This thermoplastic material is herein defined as being any organic polymer capable of repeatedly being softened when heated and hardened again when cooled. Thus, the definition excludes all organic materials that cure (such as epoxies and thermosets); and it excludes all non-organic materials (such as eutectic alloys).

Stated another way, thermoplastic materials are herein defined to be those organic polymers that are comprised of long molecular chains, which chains do not link together by covalent bands when the material is heated to its melting temperature and then cooled. Thus, the process of heating and cooling can be repeated indefinitely.

Polyphenylene sulfide, polysulfone, and polyethylene are three preferred thermoplastic materials for use in this invention. They have respective melting points of $600^{\circ}F$, $500^{\circ}F$, and $250^{\circ}F$. Thus, one of these materials may be chosen over the others depending upon one's preference to use relatively high or relatively low temperature processing.

Other preferred thermoplastic materials include acrylics, nylon, phenylene oxide, polycarbonate, polypropylene, polystyrene, and polyvinyl. Also, mixtures of the above named thermoplastics may be used to obtain the desired melting temperature. — . . . .

After the thermoplastic material 20a has been placed in the cavity, it is softened by heat from a hot iron 22. Chip 11a is then placed in the softened thermoplastic material by a vacuum tool 23. This step is illustrated in Figure 2B. Thereafter, the thermoplastic material 20a is allowed to cool and reharden.

As the cooling occurs, the thermoplastic material shrinks and thereby mechanically adheres chip 12a to the substrate. That is, at a microscopic level, those surfaces of chip 11a and substrate 12 which are in contact with the thermoplastic material are quite rough; and as the thermoplastic material contracts on cooling, it squeezes these rough surfaces to thereby hold them in place.

Subsequently as illustrated in Figure 2C, the vacuum tool 23 is retracted; and a thermal compressor 24 bonds the leads 13 to the substrate conductors 15. Note that the other ends of leads 13 were previously attached to the chip by a conventional step, not shown. Then tool 24 is retracted; and the resulting IC package is as illustrated in Figure 2D.

Reference should now be made to Figures 3A and 3B, wherein the steps for removing an attached chip are illustrated. As an initial step, those leads 13 which attach to the chip that is to be removed are cut by a knife 31. This leaves a small stub 14a on substrate 12 which can either be scraped off, or simply left in place as they do not hinder the reattachment process. Then as illustrated in Figure 3B, the thermoplastic material 20a is softened by heat; and chip 11a is removed via a pair of tweezers 32. Thereafter a new die is attached to the substrate in the same manner as was previously described in conjunction with Figures 2B-2D.

One very attractive feature of this multichip package 10 is the ease with which defective chips in the package can be replaced. As described above, that replacement process simply involves the application of heat to soften the thermoplastic material 20a; and the cooling of that material to reharden it after a new chip has been imbedded in it.

The temperature at which this softening occurs remains essentially constant, even after the repair procedure has been repeated several times. This is because no chemical change (e.g., cross-linking of molecules) takes place in the thermoplastic material during the heating and cooling steps. Also, no burning or charring of the thermoplastic material occurs during the heating step and thus no solid residue of that material needs to be removed.

One preferred embodiment of the invention has now been described in detail. But in addition, however, many changes and modifications can be made to this embodiment without departing from the nature and spirit of the invention. For example, thermally conductive fillers may be mixed with the thermoplastic material. Boron nitrite is one example of a filler that is thermally conductive but not electrically conductive; while silver is an example of a filler that is both thermally and electrically conductive.

Also as another alternative, the surface of substrate 12 to which chips are attached need not have any cavities. That is, it may be flat. In that case, the attachment and reattachment process proceeds as illustrated in Figures 2A-2D and 3A, 3B with the exception that the piece of thermoplastic material 20a is merely placed at some predetermined location on the flat substrate.

Also it is to be understood, that substrate 12 may be comprised of many materials. For example, it may be a ceramic, a metal covered with porcelain, or an ep xy glass printed circuit board. Also, substrate 12 may be flexible; in which case, it could be made of a polyim de or an epoxy, for example.

As still another alternative, the sequence of steps illustrated in Figures 2B and 2C can be reversed. That is, the leads 14 may be bonded to the substrate conductors 15 prior to imbedding chip 11a in the thermoplastic material. Also, the leads 14 may be individually wire bonded, instead of all being bonded at the same time as illustrated. Further, the leads 14 may be attached to the substrate conductors 15 by solder, in which case the lead cutting step of Figure 3A and lead attaching step of Figure 2C would be replaced by a simple solder reflow operation.

Therefore, since many modifications may be made to the above described details of the preferred embodiment, it is to be understood that the invention is not limited to said details but is defined by the appended claims.

WHAT IS CLAIMED IS:

1. An integrated circuit package comprised of a substrate, a first integrated circuit chip, and a thermoplastic material rigidly attaching said first chip to said substrate; said thermoplastic material including any organic polymer capable of repeatedly being softened when heated and hardened again when cooled, and being disposed in a manner that enables said first chip to be removed from said substrate and replaced with a second chip by a softening-hardening sequence.

2. An integrated circuit package according to Claim 1 wherein said thermoplastic material is selected from the group consisting of polyethylene, polysulfone, polyphenylene sulfide, acrylics, nylon, phenylene oxide, polycarbonate, polypropylene, polystyrene, and polyvinyl.

3. An integrated circuit package according to Claim 1 wherein said thermoplastic material is mixed with a thermally conductive filler material.

4. An integrated circuit package according to Claim 1 wherein said thermoplastic material is mixed with an electrically conductive filler material.

5. An integrated circuit package according to Claim 1 wherein said substrate has a cavity, said thermoplastic material partially fills said cavity, and said first chip has a backside surface imbedded in said thermoplastic material.

6. An integrated circuit package according to Claim 1 wherein said substrate has a substantially flat major surface, a layer of said thermoplastic material covers a predetermined portion of said major surface, and said first chip has a backside surface imbedded in said thermoplastic material.

7. An integrated circuit package according to Claim 1 wherein said integrated circuit package further includes at least one other integrated circuit chip rigidly attached to said substrate with said thermoplastic material in a manner that enables said other chip to be removed and replaced.

8. An integrated circuit package according to Claim 1 wherein said substrate is selected from the group consisting of a ceramic, a porcelain coated metal, and an epoxy glass printed circuit board.

9. An integrated circuit package according to Claim 1 wherein said integrated circuit package further includes a plurality of electrical leads bonded between respective pads on said first chip and said substrate.

Fig. 1A

13

14

15

15a

Fig. 1B

Fig. 2A

Fig. 2B

Fig. 2C

Fig. 2D

Fig. 3A

Fig. 3B

**0051165**



| | European Patent Office | EUROPEAN SEARCH REPORT | Application number |
|---|---|---|---|
| | | | EP 81 10 8107.4 |

## DOCUMENTS CONSIDERED TO BE RELEVANT

| Category | Citation of document with indication, where appropriate, of relevant passages | Relevant to claim |
|---|---|---|
| X | IBM TECHNICAL DISCLOSURE BULLETIN Vol. 14, No. 11, April 1972 New York W.E. DUNKEL "Replaceable Chip To Heat Sink Connection on Circuit Boards" page 3332 -- | 1-3,5, 7-9 |
| A | US - A - 4 184 133 (R.W. GEHLE) * column 2, lines 40 to 50; column 5, line 22 to column 6, line 3; fig. 7 * -- | 1,3,6, 7,9 |
| D,A | US - A - 3 805 123 (P. RIEGER) * claim 1 * -- | |
| D,A | US - A - 4 012 832 (J.R. CRANE) * claims 1 to 4; column 3, lines 30 to 61 * ---- | |

**CLASSIFICATION OF THE APPLICATION (Int. Cl.3)**

H 01 L 23/14

**TECHNICAL FIELDS SEARCHED (Int. Cl.3)**

H 01 L 21/52
H 01 L 23/12
H 01 L 23/40
H 01 L 25/04

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X | The present search report has been drawn up for all claims

| Place of search | Date of completion of the search | Examiner |
|---|---|---|
| Berlin | 25-01-1982 | GIBBS |

EPO Form 1503.1  06.78